# EUROPEAN PATENT APPLICATION

(11) **EP 1 577 689 A1**
(43) Date of publication of application: **21.09.2005**
(21) Application number: 05090054.7
(22) Date of filing: 07.03.2005
(51) Int. Cl.: G02B 6/42, H01R 12/04, H01R 4/02

(54) **Pin header**

(30) Priority: 19.03.2004 US 804902
(71) Applicant: Infineon Technologies AG, 81669 München (DE)
(72) Inventor: Cook, Kirk, Lyons, CO 80540 (US); Duncan, James, Loveland, CO 80538 (US)
(74) Representative: Müller, Wolfram Hubertus

(57) **Abstract**

A pin header for a transceiver comprises a frame comprising a rectangle that is indented on opposing sides of the rectangle, a first row of pins extending through the frame at a first angle to the rectangle, and a second row of pins extending through the frame at a second angle to the rectangle. The first row of pins is along a first side of the frame between the indented opposing sides and the second row of pins is along a second side of the frame between the indented opposing sides.

## Description

### Background

Fiber optic transceivers are used in a variety of applications, including storage area networks (SANs), local area networks (LANs), Fibre Channel, Gigabit Ethernet, and synchronous optical network (SONET) applications. Fiber optic transceivers can be used as the network interface in mainframe computers, workstations, servers, and storage devices. Fiber optic transceivers can also be used in a broad range of network devices, such as bridges, routers, hubs, and local and wide area switches.

To promote the growth of the market for fiber optic transceivers, an industry standard has been developed based upon an agreement between several fiber optic transceiver manufacturers entitled "Cooperation Agreement for Small Form-factor Pluggable Transceivers", as executed on September 14, 2000 (herein "the Cooperation Agreement"), which is incorporated herein in its entirety. The Cooperation Agreement specifies the package outline, circuit board layout, and pin function definitions for small form factor transceivers. One of the standard small form factor transceivers specified includes ten input/output (I/O) pins. Up to ten pins are mounted on one side of the transceiver package and up to ten pins are mounted on the opposite side of the transceiver package. The pins are secured to a printed circuit board (PCB) within the transceiver housing and extend through the transceiver housing for coupling to a host.

Typically, two rows of at least five pins are manually soldered onto the printed circuit board for the I/O pins. The pins are typically edge clip pins or pin header assemblies soldered to the printed circuit board. The pins must be manually-aligned and the soldering process typically requires several steps. The manual soldering process adds to the cost of manufacturing of the transceivers. Also, as a pin header is soldered to a PCB, wicking between pins in the header may occur causing solder to flow between pins. This can result in a short between pins.

In addition, many currently used I/O pins do not have sufficient rigidity resulting in the pins easily bending out of alignment. Bent pins can come into contact with the metallic housing of the transceiver and create electrical shorts possibly leading to failure of the transceiver.

### Summary

One embodiment of the invention provides a pin header for a transceiver. The pin header for a transceiver comprises a frame comprising a rectangle that is indented on opposing sides of the rectangle, a first row of pins extending through the frame at a first angle to the rectangle, and a second row of pins extending through the frame at a second angle to the rectangle. The first row of pins is along a first side of the frame between the indented opposing sides and the second row of pins is along a second side of the frame between the indented opposing sides.

### Brief Description of the Drawings

Embodiments of the invention are better understood with reference to the following drawings. The elements of the drawings are not necessarily to scale relative to each other. Like reference numerals designate corresponding similar parts.
Figure 1 is a diagram illustrating one embodiment of a small form factor transceiver.
Figure 2 is a diagram illustrating a sectional view of one embodiment of pins of the pin header extending through apertures in the housing of the small form factor transceiver.
Figure 3 is a diagram illustrating one embodiment of a printed circuit board for the small form factor transceiver with mounted pin header.
Figure 4 is a diagram illustrating a sectional view of one embodiment of the printed circuit board with mounted pin header.
Figure 5 is a diagram illustrating the placement of the pin header on the printed circuit board.
Figure 6 is a diagram illustrating a perspective view of one embodiment of the pin header.
Figure 7 is a diagram illustrating a top view of one embodiment of the pin header.
Figure 8 is a diagram illustrating a side view of one embodiment of the pin header.
Figure 9 is a diagram illustrating an end view of one embodiment of the pin header.
Figure 10 is a diagram illustrating one embodiment of one pin of the pin header.

### Detailed Description

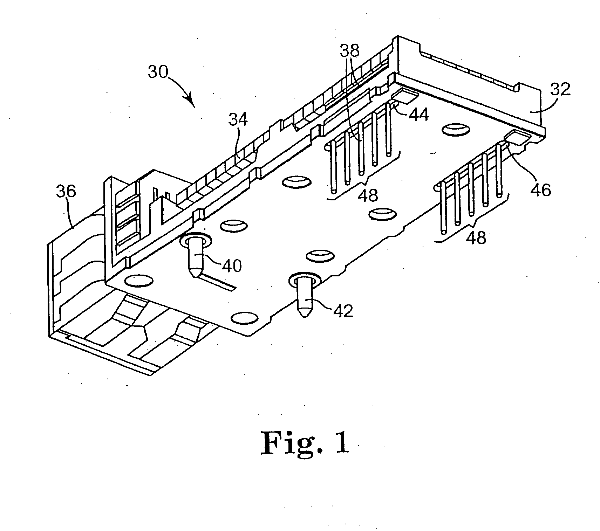

Figure 1 is a diagram illustrating one embodiment of a small form factor transceiver 30. Transceiver 30 is shown without a cover installed. Transceiver 30 includes housing 32, connector receptacle 36, printed circuit board (PCB) 34, and pin header 38. Pin header 38 includes ten pins 48 arranged into two rows of five pins each. In other embodiments, pin header 38 includes more than ten pins 48, such as fourteen pins in two rows of seven pins each. The two rows are situated on opposite sides of transceiver 30. One row of five pins is on one side of transceiver 30 and the other row of five pins is on the other side of transceiver 30. Housing 32 includes mounting studs 40 and 42 and apertures 44 and 46. Connector receptacle 36 and PCB 34 are coupled to housing 32. Pin header 38 is coupled (soldered) to PCB 34.

Mounting studs 40 and 42 are situated on opposite sides of transceiver 30. Mounting stud 40 is on one side of transceiver 30 and mounting stud 42 is on the other side of transceiver 30. Mounting studs 40 and 42 are used to mount transceiver 30 to a host. Pins 48 of pin header 38 are used to pass signals between transceiver 30 and the host. One row of five pins 48 extends through aperture 44 of housing 32 and the other row of fives pins 48 extends through aperture 46 of housing 32. Both rows of five pins 48 couple to the host. Housing 32 is made of metal, plastic, or another suitable material. In one embodiment, transceiver 30, and spacing of pins 48, conforms to the industry standard small from factor transceiver specifications.

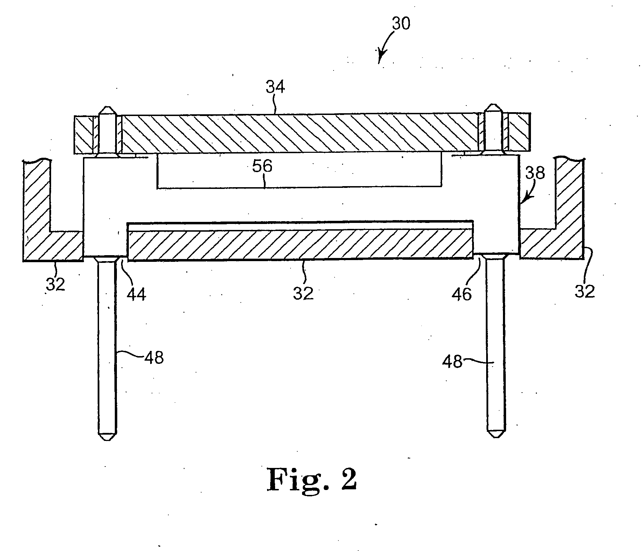

Figure 2 is a diagram illustrating a sectional view of one embodiment of pins 48 of pin header 38 extending through apertures 44 and 46 of housing 32 of transceiver 30. Transceiver 30 includes PCB 34, pin header 38, and housing 32. Pin header 38 includes frame 56 and pins 48. Pin header 38 is secured (soldered) to PCB 34 such that one row of five pins 48 extends through aperture 44 and the other row of five pins 48 extends through aperture 46. Frame 56 extends into aperture 44 to prevent the row of five pins 48 extending through aperture 44 from contacting housing 32. Frame 56 also extends into aperture 46 to prevent the other row of five pins 48 extending through aperture 46 from contacting housing 32.

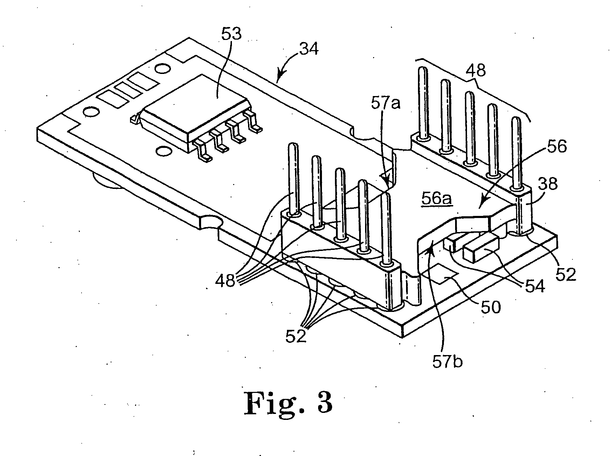

Figure 3 is a diagram illustrating one embodiment of PCB 34 of transceiver 30. PCB 34 includes pin header 38, test point 50, ten pre-plated through holes 52 that receive pins 48 of pin header 38, and transceiver components 53 and 54. Pin header 38 includes tens pins 48 and frame 56.

Pins 48 are partially encased in frame 56 to maintain the alignment of pins 48. Frame 56 is rectangular with indented sides at 57a and 57b forming an hourglass shaped frame 56. Surface 56a of frame 56 is flat so pin header 38 can be handled by automated pick and place equipment. Automated pick and place equipment place pin header 38 on PCB 34 such that pins 48 are inserted into corresponding pre-plated through holes 52 of PCB 34. Pin header 38 is secured to PCB 34 by soldering pins 48 into the corresponding pre-plated through holes 52 of PCB 34. In one embodiment, a solder reflow process is used to solder pins 48 into pre-plated through holes 52.

Pogo-pin testing of PCB 34 can be performed after PCB 34 is installed in housing 32 as the hourglass shape of frame 56 allows a tester access to test point 50. In addition, the shape of frame 56 allows enough clearance such that components 54 can be mounted on PCB 34 underneath pin header 38.

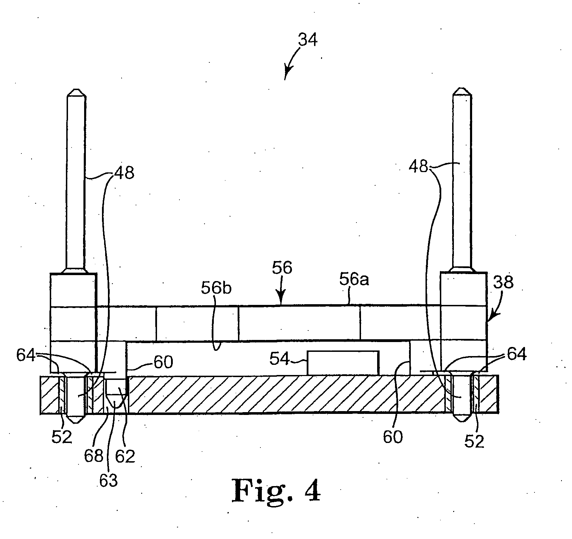

Figure 4 is a diagram illustrating a side view of PCB 34 with mounted pin header 38. Pin header 38 includes pins 48, frame 56, standoffs 60, and alignment studs 62. Alignment studs 62 include conical tips 63. Component 54 can be mounted on PCB 34 underneath frame 56 of pin header 38. Pins 48 extend through pre-plated through holes 52 in PCB 34 and are soldered in pre-plated through holes 52. In one embodiment, pre-plated through holes 52 comprise copper.

Standoffs 60 support pin header 38 on PCB 34. Standoffs 60 prevent solder from flowing between pins 48 in each row of pins during the soldering process by leaving enough space, indicated at 64, around each pin 48 to prevent wicking between pins 48. Alignment studs 62 (only one alignment stud is visible in Figure 4), are located on opposite corners of pin header 38 and extend parallel to pins 48. The alignment studs 62 are inserted into corresponding alignment stud holes 68 in PCB 34.

Conical tips 63 of alignment studs 62 assist in the placement of pin header 38 on PCB 34 during manufacturing. Pick and place equipment place conical tips 63 into alignment stud holes 68 and release pin header 38. Pin header 38 falls into the correct position on PCB 34 as conical tips 63, and thus alignment studs 62 move to the center of alignment stud holes 68. This alignment process positions pins 48 in the desired location relative to PCB 34.

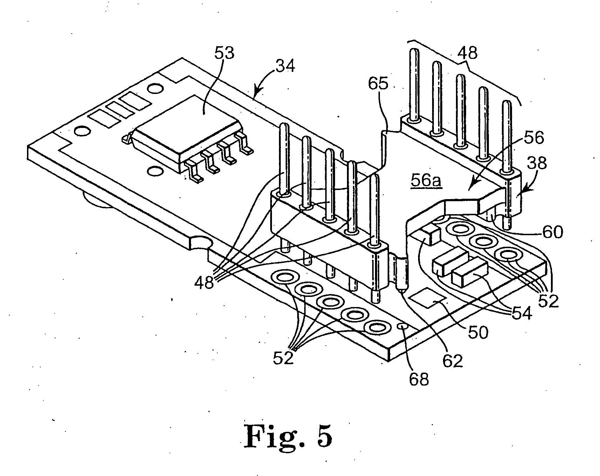

Figure 5 is a diagram illustrating the placement of pin header 38 on PCB 34. PCB 34 includes the ten pre-plated through holes 52, components 53 and 54, test point 50, and alignment stud holes 68. Pin header 38 includes pins 48 and frame 56. Frame 56 includes standoffs 60 and alignment studs 62. One alignment stud 62 and the corresponding alignment stud hole 68 are located at the opposite corner of frame 56, indicated at 65, and are not visible in Figure 5.

To place pin header 38 on PCB 34, a pick and place tool automatically positions pin header 38 such that pins 48 are started in holes 52. Alignment studs 62 align themselves with the corresponding alignment stud holes 68 of PCB 34 as pin header 38 is lowered into place. In addition, the pins 48 are aligned with the corresponding pre-plated through holes 52 of PCB 34.

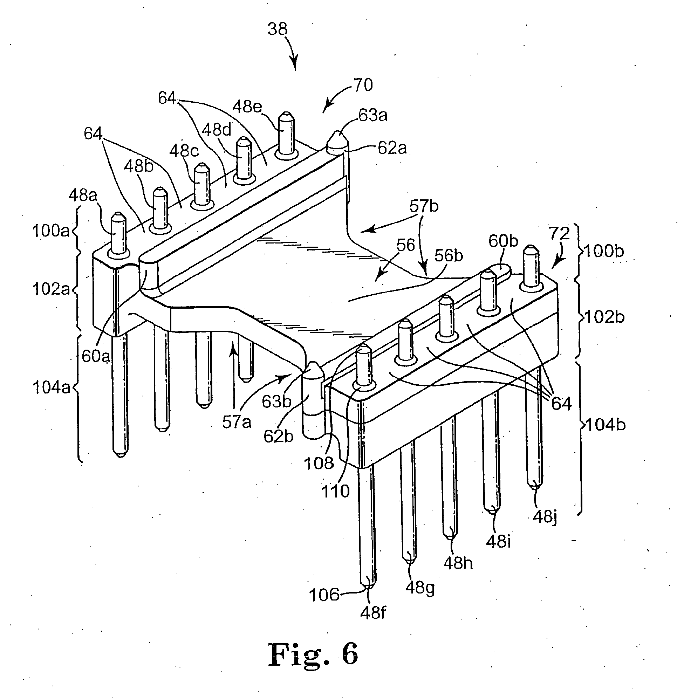

Figure 6 is a diagram illustrating a perspective view of one embodiment of pin header 38. Pin header 38 includes the tens pins 48a - 48j captured in frame 56. Frame 56 includes standoffs 60a and 60b and alignment studs 62a and 62b. Alignment stud 62a includes conical tip 63a and alignment stud 62b includes conical tip 63b. Pins 48a - 48j are arranged in two rows 70 and 72 on opposite sides of frame 56. The first row 70 of five pins includes pins 48a - 48e and the second row 72 of five pins includes pins 48f - 48j. In one embodiment, the center pin to center pin distance between the rows 70 and 72 of pins 48 is within the range of 9 mm to 11 mm, such as 10.16 mm per the Cooperation Agreement previously incorporated herein by reference.

Pins 48a - 48j extend through frame 56 and include a shorter tail portion 100a and 100b extending up from frame 56, a captured portion 102a and 102b within frame 56, and a longer contact portion 104a and 104b extending down from frame 56. The tail portions 100a and 100b of pins 48a - 48j are configured for mounting in pre-plated through holes 52 of PCB 34. The captured portions 102a and 102b of pins 48a - 48j are enclosed within frame 56 to prevent movement of pins 48a - 48j. In one embodiment, pins 48a - 48j can withstand (remain in frame 56) up to a nine pound pull out force. The contact portions 104a of pins 48a - 48e extend through aperture 46 of housing 32 and the contact portions 104b of pins 48f - 48j extend through aperture 44 of housing 32. Pins 48a - 48j are configured to electrically couple transceiver 30 to a host for transmitting signals between transceiver 30 and the host.

In one embodiment, pins 48a - 48j are round and made of copper or brass and are plated with gold for greater electrical conductivity.at solder joints and contacts. In one embodiment, the ends of pins 48a - 48j are not plated while the rest of the pin is plated. Pins 48a - 48j are rigid to resist bending and have a diameter within the range of 0.4 mm to 0.5 mm. The lengths of pins 48a - 48j are similar and within the range of 8 mm to 11 mm. Both ends of pins 48a - 48j are chamfered or rounded, such as at the ends 106 and 108 of pin 48f.

Frame 56 includes standoffs 60a and 60b and alignment studs 62a and 62b. Standoffs 60a and 60b support pin header 38 on PCB 34 and form voids 64 between and around pins 48a - 48e and pins 48f - 48j, respectively. Voids 64 prevent solder from flowing between pins 48a - 48e and pins 48f - 48j to prevent wicking during the soldering of pin header 38 to PCB 34.

Alignment stud 62a extends upward from the end of standoff 60a and alignment stud 62b extends upward from the end of standoff 60b. The conical tip 63a extends upward from alignment stud 62a and the conical tip 63b extends upward from alignment stud 62b. Conical tips 63a and 63b ease the alignment of alignment studs 62a and 62b into alignment stud holes 63 of PCB 34.

Frame 56 is comprised of a liquid crystal polyiner that is injection molded around pins 48a - 48j. In another embodiment, frame 56 is formed first and pins 48a - 48j are post inserted into frame 56. Frame 56 extends around pins 48a - 48j at captured portions 102a and 102b. In one embodiment, such as where pins 48a - 48j are overmolded, frame 56 extends conically toward the ends of pins 48a - 48j, such as at 110 of pin 48f. In another embodiment, such as where pins 48a - 48j are post inserted into frame 56, conical portions, such as 110, are not included in frame 56.

Frame 56 has a rectangular shape with indentations at 57a and 57b to form an hourglass shape. Frame 56 includes a flat surface 56b opposite surface 56a (not visible in Figure 6). In one embodiment, frame 56 can withstand soldering temperatures up to 220 °C. In another embodiment, frame 56 can withstand soldering temperatures up to 300 °C.

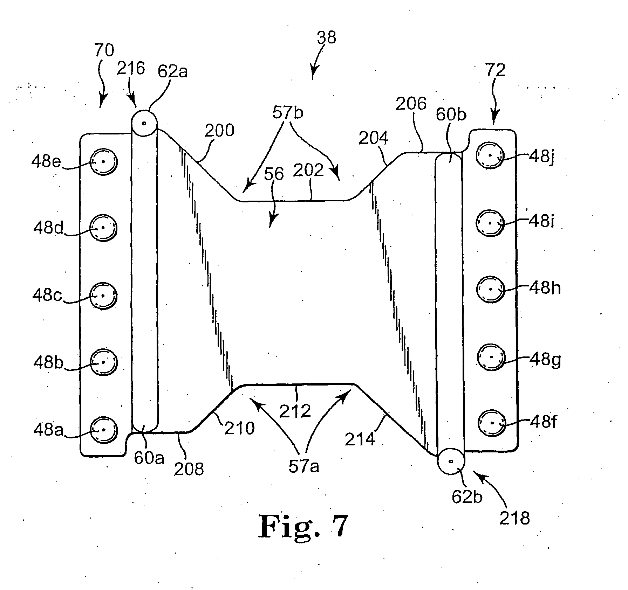

Figure 7 is a diagram illustrating a top view of one embodiment of pin header 38. Pin header 38 includes pins 48a - 48j and frame 56. Frame 56 includes standoffs 60a and 60b and alignment studs 62a and 62b. Frame 56 is rectangular with indented sides 57a and 57b to from an hourglass shape. One side 57b of the hourglass of frame 56 includes edges 200, 202, 204, and 206. The other side 57a of the hourglass of frame 56 includes edges 208, 210, 212, and 214. Edge 206 is perpendicular to standoff 60b and extends from standoff 60b to edge 204. Edges 204 and 200 angle inward toward the center 112 of frame 56 to edge 202. Edge 208 is perpendicular to standoff 60a and extends from standoff 60a to edge 210. Edges 210 and 214 angle inward toward the center 112 of frame 56 to edge 212. Edges 212 and 202 are parallel to each other.

Alignment stud 62a is positioned at an end of standoff 60a and alignment stud 62b is positioned at an end of standoff 62b. Alignment studs 62a and 62b are positioned at opposite corners 216 and 218 of frame 56. Alignment studs 62a and 62b are circular in shape and standoffs 60a and 60b are rectangular in shape with rounded ends.

Pin row 70 including pins 48a - 48e is parallel to pin row 72 including pins 48f-48j. Pin 48a is directly opposite pin 48f, pin 48b is directly opposite pin 48g, pin 48c is directly opposite pin 48h, pin 48d is directly opposite pin 48i, and pin 48e is directly opposite pin 48j. Pins 48a - 48e of row 70 are equally spaced and pins 48f - 48j of row 72 are equally spaced. In one embodiment, the center pin to center pin spacing between pins 48a - 48e and between pins 48f - 48j is within the range of 1 mm to 2 mm.

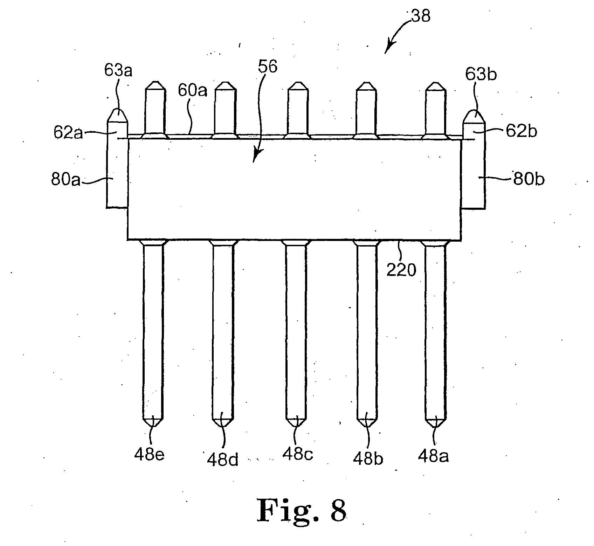

Figure 8 is a diagram illustrating a side view of one embodiment of pin header 38. Pin header 38 includes pins 48a - 48e and frame 56. Frame 56 includes standoff 60a and alignment studs 62a and 62b. Alignment stud 62a includes conical tip 63a and alignment stud 62b includes conical tip 63b. Frame 56 also includes alignment stud bases 80a and 80b. Alignment stud bases 80a and 80b extend outwardly from frame 56 and are raised with respect to the bottom or one side, indicated at 220, of frame 56.

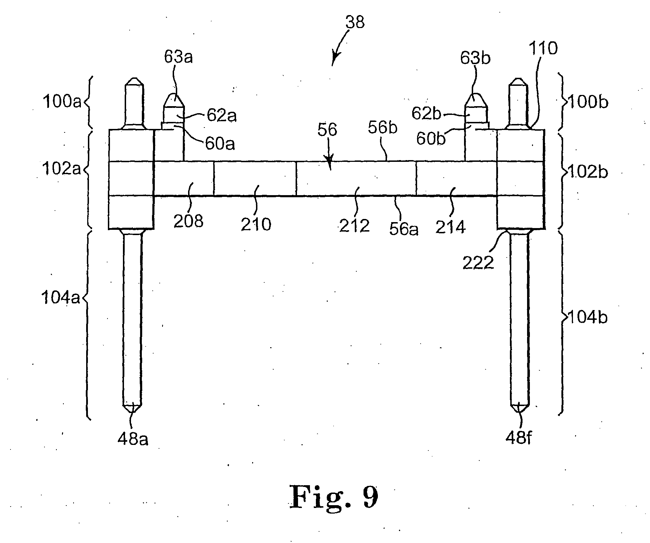

Figure 9 is a diagram illustrating an end view of one embodiment of pin header 38. Pin header 38 includes pins 48a and 48f and frame 56. Frame 56 includes edges 208, 210, 212, and 214, conical portions 110 and 222, standoffs 60a and 60b, and alignment studs 62a and 62b. Alignment studs 62a includes conical tip 63a and alignment stud 62b includes conical tip 63b. Pin 48a includes tail portion 100a, captured portion 102a, and contact portion 104a. Pin 48f includes tail portion 100b, captured portion 102b, and contact portion 104b. In one embodiment, such as where pins 48 are overmolded, conical portions, such as 110, extend from frame 56 toward pins 48 tail portions, such as 100a and 100b. Conical portions, such as 222, extend from frame 56 toward pins 48 contact portions, such as 104a and 104b. In another embodiment, such as where pins 48 are post inserted, conical portions, such as 110 and 222, are not included in frame 56.

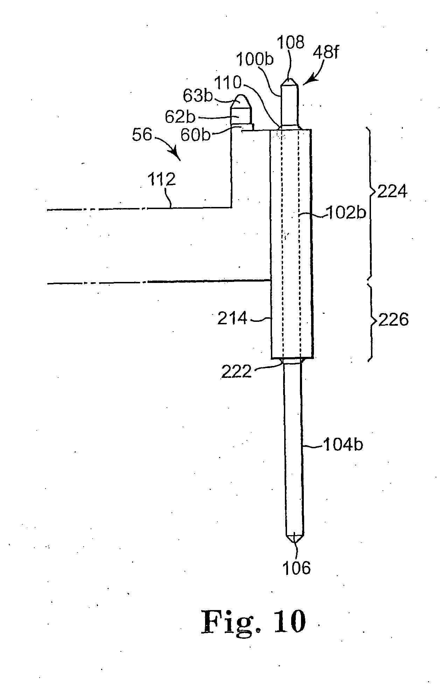

Figure 10 is a diagram illustrating one pin 48f in frame 56 of pin header 38. Pin 48f includes the tail portion 100b, captured portion 102b, and contact portion 104b. The end 108 of tail portion 100b is chamfered or rounded and the end 106 of contact portion 104b is chamfered or rounded. The length of tail portion 100b is within the range of 1 mm to 2 mm. The length of captured portion 102b is within the range of 2 mm to 3 mm. The length of contact portion 104b is within the range of 4 mm to 6 mm.

Frame 56 includes the center portion 112, a tail capture portion 224, and a contact capture portion 226. Tail capture portion 224 includes conical portion 110 extending from frame 56 toward the end 108 of tail portion 100b and contact capture portion 226 includes conical portion 222 extending from frame 56 toward the end 106 of contact portion 104b. In another embodiment, conical. portions 110 and 222 are not included in frame 56. Tail capture portion 224 extends above center portion 112 and contact capture portion 226 extends below center portion 112. In one embodiment, tail capture portion 224 is wider than contact capture portion 226.

Tail capture portion 224 maintains a space between center portion 112 and PCB 34 to allow other components to be mounted on PCB 34 above center portion 112. With pin header 38 installed in housing 32, contact capture portion 226 and conical portion 222 prevent pin 48f from contacting housing 32 and causing a short. The other pins 48 in pin header 38 are similarly configured to pin 48f.

## Claims

1. A pin header for a transceiver, comprising:
a frame;
a first row of pins extending through the frame at a first angle; and
a second row of pins extending through the frame at a second angle,
wherein the first row of pins is along a first side of the frame and between indented opposing sides of the frame and the second row of pins is along a second side of the frame and between the indented opposing sides of the frame.

2. The pin header of claim 1, wherein the first angle is 90 degrees and the second angle is 90 degrees.

3. The pin header of claim 1, comprising:
a first standoff next to the first row of pins; and
a second standoff next to the second row of pins, wherein the first standoff and the second standoff are configured to prevent wicking between pins as the pin header is soldered into place.

4. The pin header of claim 1, comprising:
a first alignment stud in one corner of the frame.

5. The pin header of claim 4, comprising;
a second alignment stud in another corner of the frame.

6. The pin header of claim 1, wherein the pins comprise at least one of brass and copper.

7. The pin header of claim 1, wherein the pins are at least partially gold plated.

8. The pin header of claim 1, wherein the pins are round.

9. The pin header of claim 1, wherein the first row of pins comprises five pins and the second row of pins comprises five pins.

10. The pin header of claim 1, wherein each of the pins has a first end and a second end and the first end and the second end are rounded.

11. The pin header of claim 1, wherein the pins are between 0.4 mm to 0.5 mm in diameter and the pins are between 8 mm to 11 mm in length.

12. The pin header of claim 1, wherein a spacing between the first row of pins and the second row of pins is between 9 mm to 11 mm.

13. The pin header of claim 1, wherein a spacing between the pins in the first row of pins and in the second row of pins is between 1mm and 2mm.

14. The pin header of claim 1, wherein the pins are post inserted into the frame.

15. The pin header of claim 1, wherein the pins are overmolded in plastic by the frame.

16. A pin header for a small form factor transceiver comprising:
a frame;
a first row comprising five pins partially encased in a first portion of the frame; and
a second row comprising five pins partially encased in a second portion of the frame, wherein the first portion and the second portion are on opposing sides of the frame and the first portion and the second portion are coupled together by a third portion of the frame.

17. The pin header of claim 16, wherein the frame comprises an hourglass shape.

18. The pin header of claim 17, wherein the first portion is at one end of the hourglass shape and the second portion is at another end of the hourglass shape.

19. The pin header of claim 16, wherein the frame comprises a first standoff adjacent the first row and a second standoff adjacent the second row, the first standoff and the second standoff are configured to maintain spacing between the pins and a printed circuit board.

20. The pin header of claim 16, wherein the frame comprises an alignment stud for aligning the pin header on a printed circuit board.

21. The pin header of claim 16, wherein the third portion of the frame comprises a flat surface configured for picking and placing by automated equipment.

22. The pin header of claim 16, wherein the frame comprises plastic.

23. The pin header of claim 16, wherein the frame is configured to withstand soldering temperatures greater than 220 degrees C.

24. A small form factor transceiver comprising:
a housing;
a printed circuit board; and
a two row by five pin header comprising ten pins soldered to the printed circuit board, wherein the tens pins are aligned to extend through apertures in the housing.

25. The small form factor transceiver of claim 24, wherein the two row by five pin header is configured to allow access to a test point on the printed circuit board between the two rows of pins.

26. The small form factor transceiver of claim 24, wherein the two row by five pin header is configured to allow components to be mounted to the printed circuit board between the two row by five pin header and the printed circuit board.

27. The small form factor transceiver of claim 24, wherein the housing comprises metal.

28. The small form factor transceiver of claim 24, wherein the two row by five pin header is configured to prevent the pins from contacting the housing.

29. The small form factor transceiver of claim 24, wherein the small form factor transceiver is a fiber optic transceiver.

30. The small form factor transceiver of claim 24, wherein the two row by five pin header is configured for soldering to the printed circuit board by automated equipment.

31. A small form factor transceiver comprising:
a housing;
a printed circuit board; and
a two row by seven pin header comprising fourteen pins soldered to the printed circuit board, wherein the fourteen pins are aligned to extend through apertures in the housing.

32. A method for soldering a pin header for a small form factor transceiver to a printed circuit board, comprising:
picking the pin header with an automated pick and place machine;
aligning an alignment stud with a stud hole;
aligning pins of the pin header into solder holes in the printed circuit board; and
soldering the pin header to the printed circuit board.

33. The method of claim 32, wherein picking the pin header comprises picking the pin header on a flat surface of the pin header.

34. The method of claim 32, wherein aligning an alignment stud with a stud hole comprises aligning a pin header alignment stud with a printed circuit board stud hole.

35. The method of claim 32, wherein soldering comprises reflow soldering.

36. The method of claim 32, comprising positioning a standoff from the pin header on the printed circuit board.
